# EUROPEAN PATENT APPLICATION

(11) **EP 4 087 008 A1**
(43) Date of publication of application: **09.11.2022**
(21) Application number: 21218117.6
(22) Date of filing: 29.12.2021
(51) Int. Cl.: H01M 10/42, G01R 31/00, H01M 10/44, H01M 10/48, H02H 7/00

(54) **DETERMINATION METHOD FOR BATTERY STATE, ELECTRONIC APPARATUS, AND STORAGE MEDIUM**

(30) Priority: 06.05.2021 CN 202110491031
(71) Applicant: Beijing Xiaomi Mobile Software Co., Ltd., Beijing 100085 (CN)
(72) Inventor: TSENG, Yaoyi, Beijing, 100085 (CN)
(74) Representative: dompatent von Kreisler Selting Werner - Partnerschaft von Patent- und Rechtsanwälten mbB

(57) **Abstract**

A determination method for a battery state, the method includes: obtaining an environment temperature sequence of an environment where a battery is located in a preset time period (S110), the environment temperature sequence including: a plurality of environment temperatures corresponding one-to-one to a plurality of time nodes; determining, according to the time nodes corresponding to the plurality of environment temperatures of the environment temperature sequence, accumulated duration that the environment temperatures greater or equal to at least one environment temperature threshold (S120); determining a state of health of the battery according to the accumulated duration and a reference duration threshold (S130); and determining, under the condition that the battery is in an unhealthy state, a regulation strategy for a charging mode, so as to charge the battery based on the adjusted charging mode (S140).

## Description

### FIELD OF THE INVENTION

The disclosure relates to the field of battery protection, and particularly relates to a determination method and device for a battery state, an electronic apparatus, and a storage medium.

### BACKGROUND

Electronic apparatuses such as mobile phones generally use lithium ion batteries, the chemical activity and the service life of which are easily influenced by temperature. As the technology advances, the battery capacity of the electronic apparatus is large, and the charging speed is also increasingly high, so the service life of the battery is more easily influenced by heating.

### SUMMARY

The disclosure relates to the field of battery protection, and particularly relates to a determination method and device for a battery state, an electronic apparatus, and a storage medium.

According to a first aspect of examples of the disclosure, provided is a determination method for a battery state. The method includes:
obtaining an environment temperature sequence of an environment where a battery is located in a preset time period, the environment temperature sequence including: a plurality of environment temperatures corresponding one-to-one to a plurality of time nodes;
determining, according to the time nodes corresponding to the plurality of environment temperatures of the environment temperature sequence, accumulated duration that the environment temperatures greater or equal to at least one environment temperature threshold;
determining a state of health of the battery according to the accumulated duration and a reference duration threshold; and
determining, under the condition that the battery is in an unhealthy state, a regulation strategy for a charging mode, so as to charge the battery based on the adjusted charging mode. In all embodiments of the present invention a time node can be interpreted as an instant of time or a point in time in which a certain event occurs.

Optionally, the determining accumulated duration that the environment temperatures greater or equal to at least one environment temperature threshold comprises:
when the environment temperature threshold is set to a plurality, respectively determining, in the environment temperature sequence, the accumulated duration corresponding to each of the environment temperature thresholds.

Optionally, the determining a state of health of the battery according to the accumulated duration and a reference duration threshold comprises:
obtaining first configuration information, the first configuration information comprising: one-to-one relations between the plurality of environment temperature thresholds and the plurality of reference duration thresholds in different time periods;
determining, according to the first configuration information, the reference duration threshold corresponding to each of the environment temperature thresholds in the preset time period;
responsive to at least one accumulated duration to greater or equal to the corresponding reference duration threshold, and determining that the battery is in the unhealthy state in the preset time period.

Optionally, further comprising, under the condition that the battery is in the unhealthy state:
displaying a prompt interface.

Optionally, the prompt interface comprises a plurality of display areas; and the displaying a prompt interface comprises:
displaying battery condition information in the preset time period on the first display area of the prompt interface, the battery condition information comprising: a state of the environment where the battery is located and the accumulated duration; and
displaying, on the second display area of the prompt interface, an adjustment suggestion based on the environment where the battery is located.

Optionally, further comprising:
receiving an operation instruction from a preset area of the prompt interface; and
controlling the prompt interface to hide or the regulation strategy to be executed according to the operation instruction.

Optionally, the determining a regulation strategy for a charging mode comprises:
adjusting a charging voltage, and adjusting a charging current.

Optionally, the determining a regulation strategy for a charging mode comprises:
adjusting a charging voltage, or adjusting a charging current.

Optionally, the adjusting a charging voltage comprises:
obtaining a reference charging voltage and a voltage adjust parameter, the voltage adjust parameter being used for adjusting the reference charging voltage down; and
determining an adjusted charging voltage according to the reference charging voltage and the voltage adjust parameter.

Optionally, the adjusting a charging current comprises:
obtaining an old charging current and a current adjustment parameter, the current adjustment parameter being used for adjusting the old charging current down; and
determining an adjusted charging current according to the old charging current and the current adjustment parameter.

According to a second aspect of examples of the disclosure, provided is an electronic apparatus, including:
a processor, and
a memory configured to store an executable instruction of the processor;
the processor executes the executable instruction to implement a determination method for a battery state, and the processor configured to:
obtain an environment temperature sequence of an environment where a battery is located in a preset time period, the environment temperature sequence including: a plurality of environment temperatures corresponding one-to-one to a plurality of time nodes;
determine, according to the time nodes corresponding to the plurality of environment temperatures of the environment temperature sequence, accumulated duration that the environment temperatures greater or equal to at least one environment temperature threshold;
determine a state of health of the battery according to the accumulated duration and a reference duration threshold; and
determine, under the condition that the battery is in an unhealthy state, a regulation strategy for a charging mode, so as to charge the battery based on the adjusted charging mode.

Optionally, the processor is further configured to:
when the environment temperature threshold is set to a plurality, respectively determining, in the environment temperature sequence, the accumulated duration corresponding to each of the environment temperature thresholds.

Optionally, the processor is further configured to:
obtain first configuration information, the first configuration information comprising: one-to-one relations between the plurality of environment temperature thresholds and the plurality of reference duration thresholds in different time periods;
determine, according to the first configuration information, the reference duration threshold corresponding to each of the environment temperature thresholds in the preset time period;
responsive to at least one accumulated duration to reach the corresponding reference duration threshold, and determining that the battery is in the unhealthy state in the preset time period.

Optionally, under the condition that the battery is in the unhealthy state, the processor (520) is further configured to:
displaying a prompt interface.

According to a third aspect of examples of the disclosure, provided is a non-temporary computer-readable storage medium. When an instruction in the storage medium is executed by a processor of an electronic apparatus, the electronic apparatus can perform a determination method, the determination method including:
obtaining an environment temperature sequence of an environment where a battery is located in a preset time period, the environment temperature sequence including: a plurality of environment temperatures corresponding one-to-one to a plurality of time nodes;
determining, according to the time nodes corresponding to the plurality of environment temperatures of the environment temperature sequence, accumulated duration that the environment temperatures greater or equal to at least one environment temperature threshold;
determining a state of health of the battery according to the accumulated duration and a reference duration threshold; and
determining, under the condition that the battery is in an unhealthy state, a regulation strategy for a charging mode, so as to charge the battery based on the adjusted charging mode.

The disclosure provides a determination method for a battery state. The method includes: an environment temperature sequence of an environment where a battery is located in a preset time period is obtained. According to the time nodes corresponding to the plurality of environment temperatures of the environment temperature sequence, accumulated duration that the environment temperatures reach an environment temperature threshold is determined. A state of health of the battery is determined according to the accumulated duration and a reference duration threshold. Under the condition that the battery is in an unhealthy state, a regulation strategy for a charging mode is determined, so as to charge the battery based on the adjusted charging mode. By using the method in the disclosure, a temperature of an environment where the battery is located for a long time may be obtained in a using or storing process, and accumulated duration that a corresponding environment temperature threshold is reached is obtained, such that whether the temperature of the environment where the battery is located for a long time influences a state of health of the battery may be known, and the use or storage environment or a charging mode of the battery may be adjusted in time, so as to reduce aging or swelling of the battery, and guarantee service life of the battery.

It is to be understood that both the foregoing general description and the following detailed description are illustrative and explanatory only and are not restrictive of the disclosure.

### BRIEF DESCRIPTION OF THE DRAWINGS

The accompanying drawings, which are incorporated in and constitute a part of this specification, illustrate examples consistent with the disclosure and, together with the specification, serve to explain the principles of the disclosure.
Fig. 1 is a schematic diagram of variation in the degree of swelling of a battery at 25°C.
Fig. 2 is a schematic diagram of variation in the degree of swelling of a battery at 40°C.
Fig. 3 is a schematic diagram of variation in the degree of swelling of a battery at 45°C.
Fig. 4 is a schematic diagram of the degree of cycle aging of a battery at 25°C.
Fig. 5 is a schematic diagram of the degree of cycle aging of a battery at 40°C.
Fig. 6 is a flowchart of a method shown in some examples.
Fig. 7 is a flowchart of a method shown in some examples.
Fig. 8 is a schematic diagram of a principle shown in some examples.
Fig. 9 is a flowchart of a method shown in some examples.
Fig. 10 is a schematic diagram of a prompt interface shown in some examples.
Fig. 11 is a schematic diagram of a prompt interface shown in some examples.
Fig. 12 is a structural schematic diagram of a storage mode shown in some examples.
Fig. 13 is a relation between a charging voltage and battery life shown in some examples.
Fig. 14 is a block diagram of a device shown in some examples.
Fig. 15 is a block diagram of an electronic apparatus shown in some examples.

### DETAILED DESCRIPTION

Explanation will herein be made in detail to illustrative examples, instances of which are illustrated in the accompanying drawings. When the following description refers to the accompanying drawings, the same numbers in different accompanying drawings refer to the same or similar elements unless otherwise indicated. The implementation modes described in the following illustrative examples do not represent all implementation modes consistent with the disclosure. Rather, they are merely instances of devices and methods consistent with some aspects of the disclosure as detailed in the appended claims.

Electronic apparatuses such as mobile phones generally use lithium ion batteries, the chemical activity and the service life of which are easily influenced by temperature. As the technology advances, the battery capacity of the electronic apparatus has become larger, and the charging speed is also increasingly high, so the service life of the battery is more easily influenced by heating.

For guarantee the service life of the battery, in the related technology, there is a corresponding high-temperature protection measure when charging the battery. For instance, when it is detected that the temperature of the battery or the electronic apparatus reaches 50°C or 60°C, the electronic apparatus may reduce the charging speed or stop charging to prevent the temperature of the battery from rising too fast during charging, so as to keep the service life of the battery.

The battery is not only influenced by high temperature in the charging process, and when the battery is stored or used in an environment at a temperature 30°C or higher, the battery is also influenced by the temperature to be aged or expanded, which influences and shortens the service life of the battery. the ambient temperature may be the temperature of the environment where the battery in the terminal housing is located, or the surface temperature of the battery, or the temperature of the main board of the mobile phone. The ambient temperature can be obtained by installing NTC (Negative Temperature Coefficient) on the surface of the battery of the mobile phone, or the ambient temperature determined according to the temperature of the motherboard of the mobile phone collected by a temperature sensor.

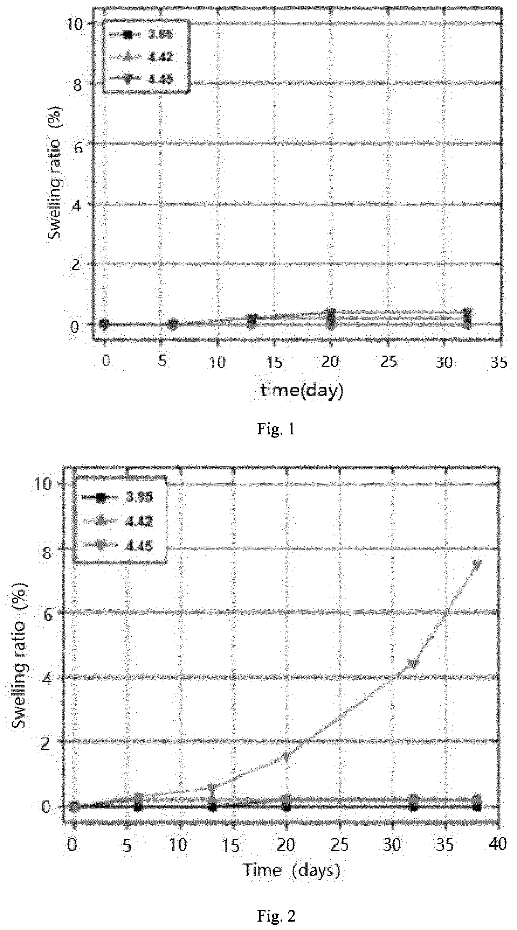

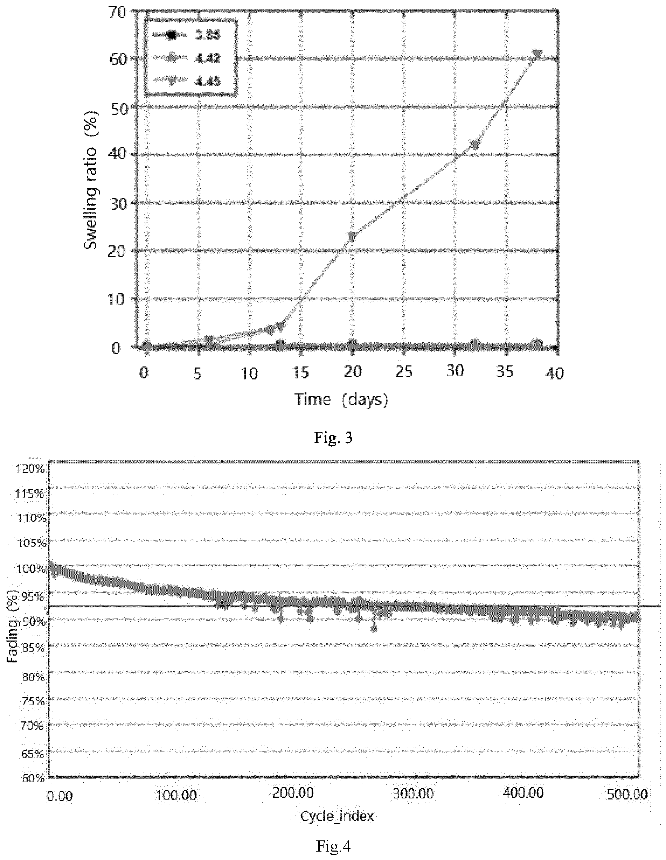

Figs. 1-3 show relations between the degree of swelling of the battery and the temperature of the environment where the battery is located under long-time use or storage. As shown in Fig. 1, when the battery is used or stored at an environment temperature of 25°C, the degree of swelling of the battery is negligible, and the battery may maintain good performance. As shown in Fig. 2, when the battery is used or stored at an environment temperature of 40°C, the degree of swelling of the battery gradually increases over time, and the service life of the battery will be influenced when in use or storage at this temperature for a certain period of time. As shown in Fig. 3, when the battery is used or stored at an environment temperature of 45°C, the degree of swelling of the battery gradually increases over time, and to a greater extent than in the case of 40°C, and use or storage at this temperature will influence the service life of the battery. As shown in Figs. 1-3, when used or stored at a high temperature, the battery is prone to swelling and the service life is influenced.

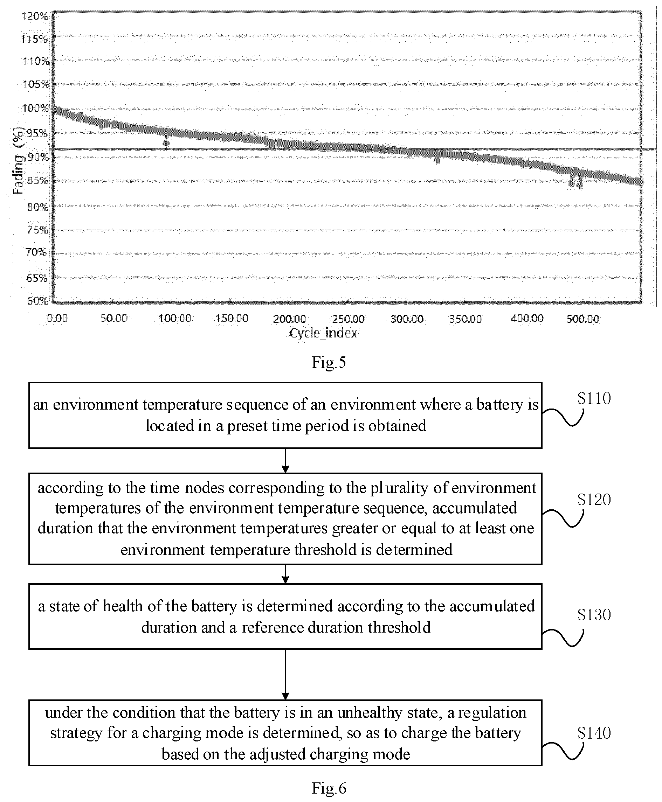

Figs. 4-5 show relations between cycle aging of the battery and the temperature of the environment where the battery is located under long-time use or storage. As shown in Fig. 4, a cycle test of the battery at an environment temperature of 25°C shows that remaining capacity of the battery is still at an optimal level when the number of cycles reaches a maximum. As shown in Fig. 5, a cycle test of the battery at an environment temperature of 40°C shows that the degree of aging of the battery increases (a slope is larger) as the number of cycles increases, and the remaining capacity of the battery at the maximum number of cycles is greatly reduced as compared with that of Fig. 4. As shown in Figs. 4-5, when used or stored at a high temperature, the battery is prone to aging and battery capacity degradation, further influencing the service life.

It may be found from the contents of Figs. 1-5 above that in addition to the temperature of the battery in the charging process, the battery life is also greatly influenced at a high temperature for a long time in the daily use or storage.

Obviously, the related technology has the following technical problems that charging protection of a specific high-temperature value (50°C or 60°C) is only set in the battery charging process, there is no high-temperature protection measure for the battery in daily life, and the protection effect needs to be improved.

For solving the problems existing in the related technology, the disclosure provides a determination method for a battery state. The method includes: an environment temperature sequence of an environment where a battery is located in a preset time period is obtained. According to the time nodes corresponding to the plurality of environment temperatures of the environment temperature sequence, accumulated duration that the environment temperatures greater or equal to at least one environment temperature threshold is determined. A state of health of the battery is determined according to the accumulated duration and a reference duration threshold. Under the condition that the battery is in an unhealthy state, a regulation strategy for a charging mode is determined, so as to charge the battery based on the adjusted charging mode. By using the method in the disclosure, a temperature of an environment where the battery is located for a long time may be obtained in a using or storing process, and accumulated duration that a corresponding environment temperature threshold is reached is obtained, such that whether the temperature of the environment where the battery is located for a long time influences a state of health of the battery may be known, and the use or storage environment or a charging mode of the battery may be adjusted in time, so as to reduce aging or swelling of the battery, and guarantee service life of the battery.

In one illustrative example, a determination method for a battery state is applied to an electronic apparatus, and the electronic apparatus may be a mobile phone, a tablet computer, a notebook computer, an intelligent wearable apparatus, etc.

As shown in Fig. 6, the method in this example may specifically include:

S110, an environment temperature sequence of an environment where a battery is located in a preset time period is obtained.

S120, according to the time nodes corresponding to the plurality of environment temperatures of the environment temperature sequence, accumulated duration that the environment temperatures greater or equal to at least one environment temperature threshold is determined.

S130, a state of health of the battery is determined according to the accumulated duration and a reference duration threshold.

S140, under the condition that the battery is in an unhealthy state, a regulation strategy for a charging mode is determined, so as to charge the battery based on the adjusted charging mode.

In step S110, the preset time period may be a period customized by a user or set by default by the electronic apparatus, for instance, one hour (h), one day, one week (7 days), or one month.

In this step, the environment temperature sequence includes: a plurality of environment temperatures corresponding one-to-one to a plurality of time nodes. The adjacent time nodes are spaced at an equal unit time, and the unit time is set according to the length of the preset time period, for instance, under the condition that the preset time period is longer, the unit time may be set to be longer.

In a first instance, in conjunction with Table 1, the preset time period is 1 h or less, and the unit time may be set as 1 min (Unit 1 min), and then the plurality of time nodes are 1 min, 2 min, 3 min,... 59 min, 1 h, that is, the environment temperature sequence includes environment temperatures corresponding to every 1 min in 1 h or less.

In a second instance, the preset time period is one day, and the unit time may be set as 0.5 h (Unit 0.5 HR), and then the environment temperature sequence includes environment temperatures corresponding to every 0.5 h in one day.

In a third instance, the preset time period is one week, and the unit time may be set as 1 h (Unit 1 HR), and then the environment temperature sequence includes environment temperatures corresponding to every 1 h in one week.

In a fourth instance, the preset time period is one month, and the unit time may be set as 0.5 day (Unit 0.5 Day), and then the environment temperature sequence includes environment temperatures corresponding to every 0.5 day in one month.

In this step, the environment temperature of the environment where the battery is located is an environment temperature of the electronic apparatus. The electronic apparatus generally includes an application layer (Apps), a system framework layer (Framework) and a bottom driving layer (Drivers), where the bottom driving layer may drive a fuel gauge (for instance, a battery fuel gauge (Battery FG) or a system end fuel gauge (power management integrated circuit, that is, PMIC)) or a sensor, for instance, a temperature sensing element, etc. to collect the environment temperature in real time, and the application layer may obtain the environment temperature detected by the sensor. A time starting point for the sensor to collect the environment temperature in real time may be, for instance, the time when configuration is completed after the electronic apparatus is started up.

In step S120, in conjunction with the equal unit time interval between the adjacent time nodes in step S110, each of the time nodes corresponds to one environment temperature. The environment temperature threshold may be, for instance, at least one high temperature threshold selected based on the fact that the battery is influenced by temperature in Fig. 1-5.

In one instance, an environment temperature threshold is set, for instance, the environment temperature threshold is set as 35°C.

In this instance, each environment temperature needs to be compared to the environment temperature threshold during obtaining the accumulated duration, and under the condition that a plurality of environment temperatures reach (greater than or equal to) the environment temperature threshold, the accumulated duration is determined as a sum of unit times experienced by the plurality of environment temperatures. Under the condition that the plurality of environment temperatures are continuous, the accumulated duration is a value obtained by subtracting a minimum time node from a maximum time node.

In another instance, in conjunction with Table 1, a plurality of environment temperature thresholds are provided, and are set as, for instance, HT1 (35°C), HT2 (39°C), and HT3 (43°C) depending on the degree of influence of the battery at different temperatures.

In this instance, in the environment temperature sequence, the accumulated duration corresponding to each of the environment temperature thresholds is determined separately. For instance, each of the environment temperatures is sequentially compared with each of the environment temperature thresholds, and the accumulated duration corresponding to each of the environment temperature thresholds is determined. Finally, the plurality of accumulated durations corresponding one-to-one to the plurality of environment temperature thresholds are obtained in the preset time period. For ease of statistics, the unit of the accumulated duration is always in hours (h) in this step.

The process of determining the accumulated duration in this step may be: the application layer or a processor (AP) of the electronic apparatus obtains temperature-time data of the sensor and then performs computing; or may be: the sensor collects environment temperature data and then performs computing and storing, and the processor obtains the accumulated duration from a storage position; or may also be: in the process that the sensor collects the environment temperature data, collection is started from the moment when the environment temperature exceeds the environment temperature threshold and stopped at the moment when the environment temperature is reduced to be lower than the environment temperature threshold, the accumulated duration is directly stored, and the processor obtains the accumulated duration from the sensor.

For instance, the fuel gauge (for instance, the Battery FG or the PMIC) directly stores the accumulated time in the process of collecting the environment temperature data. The fuel gauge carries out statistics and stores data in a rolling lifetime mode, a data file is stored to form a rolling lifetime table shown in Table 1 for the application layer or the application processor to directly read or call the temperature data. After calling the temperature data, the application layer may determine a state of health of the battery in conjunction with the environment temperature data or perform corresponding regulation.

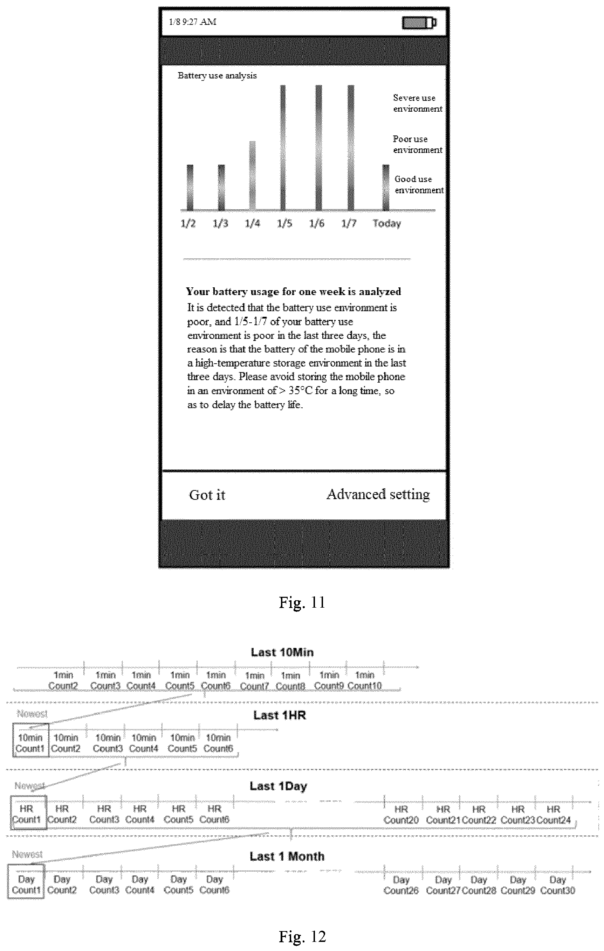

It will be appreciated that as shown in Fig. 12, in the rolling lifetime mode, for a longer preset time period, the unit time of storage is also longer, and in a Last 10 min period, the unit time of storage is 1 min, which requires 10 counts. In a Last 1 h period, the unit time of storage is 10 min, which requires 6 counts, and latest data of the Last 10 min period are used for continuously pushing data rolling in the 1 h period. In a Last 1 Day period, the unit time of storage is 1 h, which requires 24 counts, and latest data of the Last 1 h period are used for continuously pushing data rolling in the 1 Day period. The rolling lifetime mode is convenient for querying the battery temperature data of the latest time in the past, such that a storage space occupied by a large amount of data is reduced, and the battery temperature data is stored by consuming the least storage space.

Table 1 may be stored in a set storage space of the electronic apparatus, and a storage address is marked for the application layer or the processor to call Table 1.

Table 1 refers to the accumulated times of three environment temperature thresholds for different time periods (10 min, 1 h, 1 day, 1 week, 1 month). The plurality of environment temperature thresholds are HT1 (35°C), HT2 (39°C) and HT3 (43°C), and each of the environment temperature thresholds corresponds to an accumulated time in each time period. Table 1 shows an instance of specific stored data, and the accumulated time is represented in a hexadecimal number (0X), which may be converted into a binary or decimal number.

The preset time period may be any one of the different time periods in Table 1, and in conjunction with actual requirements, 1 week is taken as an instance of the preset time period in the example.

**Table 1**

| Name | Last 10 min (Unit 1 min) | Last 1 HR (Unit 1 min) | Last 1 day (Unit 0.5 HR) | Last 1 week (Unit 1 HR) | Last 1 month (Unit 1 min) | Total (HR) |
|---|---|---|---|---|---|---|
| HT1 | 0X000A | 0X000B | 0X000C | 0X000D | 0X000E | 0X0055 |
| HT2 | 0X000F | 0X0010 | 0X0011 | 0X0012 | 0X0013 | 0X0056 |
| HT3 | 0X0013 | 0X0014 | 0X0015 | 0X0016 | 0X0017 | 0X0057 |

In step S130, the reference duration threshold may be pre-stored in the electronic apparatus, and the reference duration threshold is configured to represent accumulated safety duration during which the environment temperature reaches the environment temperature threshold in the preset time period, and the state of health of the battery is considered to be uninfluenced during the accumulated safety duration.

For instance, under the condition that the reference duration threshold is 84 h and the accumulated duration does not reach the reference duration threshold, the battery is in a healthy state; and under the condition that the accumulated duration reaches the reference duration threshold, the state of health of the battery is influenced and the battery is in an unhealthy state.

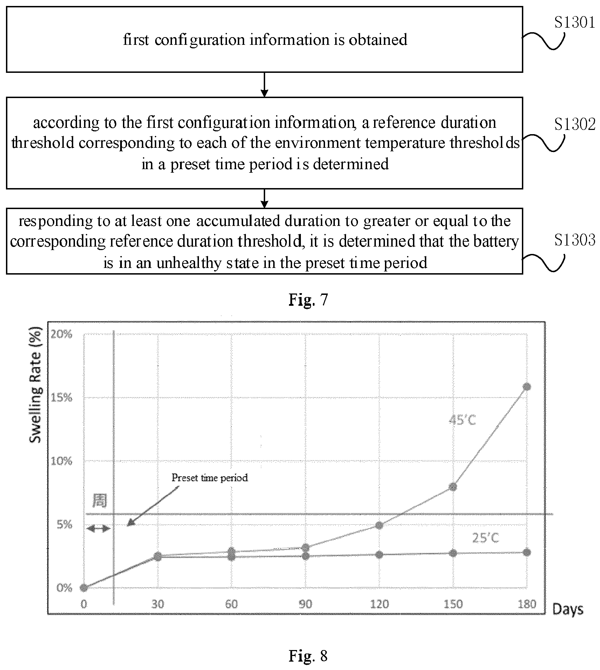

In one illustrative example, as shown in Fig. 7, step S130 in this example may specifically include:

S1301, first configuration information is obtained.

S1302, according to the first configuration information, a reference duration threshold corresponding to each of the environment temperature thresholds in a preset time period is determined.

S1303, responding to at least one accumulated duration to greater or equal to the corresponding reference duration threshold, it is determined that the battery is in an unhealthy state in the preset time period.

In step S1301, the first configuration information includes: one-to-one relations between the plurality of environment temperature thresholds and the plurality of reference duration thresholds in different time periods. The first configuration information may be pre-stored in the electronic apparatus, for instance, at the application layer.

For instance, as shown in Table 2 (which corresponds to Table 1), the first configuration information includes three environment temperature thresholds HT1 (35°C), HT2 (39°C) and HT3 (43°C), and also includes the plurality of time periods identical to those in Table 1, and a plurality of weight values corresponding one-to-one to the plurality of environment temperature thresholds in each of the time periods. In different time periods, the reference duration thresholds corresponding to the environment temperature thresholds are different. The weight value represents an influence level of the environment temperature threshold, and the larger the weight is, the larger the influence level of the environment temperature threshold on the battery is (the battery is more easily aged), and the more critical the influence on the service life of the battery is. Therefore, the reference duration threshold corresponding to the environment temperature threshold with larger weight is smaller than the reference duration threshold corresponding to the environment temperature threshold with smaller weight.

In step S1302, in conjunction with step S1301, when the plurality of environment temperature thresholds are set, each of the environment temperature thresholds corresponds to a reference duration threshold in the preset time period.

For instance, as shown in Table 2, when the preset time period is one week (last 1 week), the reference duration threshold corresponding to the environment temperature threshold HT1 (35°C) is 84 h, the reference duration threshold corresponding to the environment temperature threshold HT2 (39°C) is 70 h, and the reference duration threshold corresponding to the environment temperature threshold HT3 (43°C) is 50 h.

In step S1303, the accumulated duration corresponding to each of the environment temperature thresholds is compared with a corresponding reference duration threshold.

In conjunction with Table 1, the electronic apparatus may obtain or determine accumulated duration corresponding to different environment temperature thresholds in the preset time period. When the accumulated duration correspondingly to any environment temperature threshold reaches the reference duration threshold, in some examples: the accumulated duration in the 1-week period characterized by "0X000D" in Table 1 reaches (is greater than or equal to) the reference duration threshold of 84 h in the 1-week period in Table 2. Thus, the battery is in an unhealthy state, that is, the battery is stored or used at the high temperature for a long time, and the service life of the battery is influenced.

**Table 2**

| Name | Last 10 min (Unit 1 min) | Last 1 HR (Unit 1 min) | Last 1 day (Unit 0.5 HR) | Last 1 week (Unit 1 HR) | Last 1 month (Unit 1 min) | Total (HR) |
|---|---|---|---|---|---|---|
| HT1 | - | - | 24 (weight 1.2) | 84 (weight 1.2) | - | - |
| HT2 | - | - | 20 (weight 1.2) | 70 (weight 1.5) | 300 | 1800 |
| HT3 | - | - | 16 (weight 1.5) | 50 (weight 1.5) | 210 | 1260 |

In step S140, when the battery is in the unhealthy state, a regulation strategy based on the charging mode may be determined, and the adjusted charging mode may be executed in the charging process of the battery.

In a first instance, this step includes that a charging voltage is adjusted while the battery is in a state of charge. This instance includes:

S1401, a reference charging voltage and a voltage adjust parameter are obtained.

In this step, the reference charging voltage may be an old charging voltage in a state of charge, for instance, 4.45 V. The voltage adjust parameter is a parameter configured to adjust the old charging voltage down, which may be set in advance and stored in the electronic apparatus, and the voltage adjust parameter may be set according to the battery capacity, for instance, the voltage adjust parameter may be set to 0.2% of the battery capacity. In this instance, the voltage adjust parameter may be set as 20 mV.

S1403, an adjusted charging voltage is determined according to the reference charging voltage and the voltage adjust parameter.

In this step, adjusted charging voltage = old charging voltage - voltage adjust parameter.

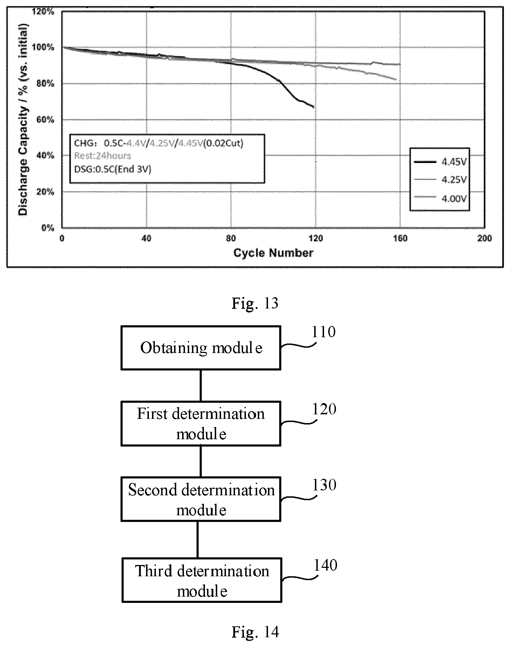

In conjunction with Fig. 13, the diagram is an effect of the charging voltage of the battery on the number of cycle aging, that is, on service life of the battery. When the charging voltage is reduced, aging may be effectively improved, and the service life of the battery is guaranteed.

In a second instance, this step includes that a charging current is adjusted while the battery is in a state of charge. This instance includes:

S1402, an old charging current and a current adjustment parameter are obtained.

In this step, the old charging current may be a default charging current in the state of charge, and the current adjustment parameter may be a parameter for adjusting the old charging current down and may be set in advance and stored in the electronic apparatus. In this instance, the current adjustment parameter may be set as 0.95.

S1404, an adjusted charging current is determined according to the old charging current and the current adjustment parameter.

In this step, adjusted charging current = old charging current ^{∗} current adjustment parameter.

In a third instance, this step includes that a charging voltage and a charging current are both adjusted while the battery is in a state of charge. The mode in which the adjusted charging voltage and charging current are determined may be seen in the two instances described above.

After each regulation for the battery in the unhealthy state, the battery state may be determined anew, and whether the regulation strategy for the charging mode is executed is determined in conjunction with the new battery state. In other examples, under the condition that the battery is determined to be in a healthy state by means of steps S110 to S130, the electronic apparatus may use a normal charging process without determining or executing the regulation strategy for the charging mode.

In this example, it is intended to determine the state of the battery during daily use or storage. In conjunction with Fig. 8, after the state of the battery in each of the time periods is obtained in real time, a user may be effectively prompted before the battery is expanded or degraded, such that the environment temperature at which the user uses or stores the battery may avoid a poor environment temperature threshold as much as possible, so as to reduce the influence of the daily temperature on the service life of the battery. For instance, as shown in Fig. 8, the user is prompted 30 days before the battery swelling, and under the condition that the user takes action, a subsequent battery swelling progress may be avoided.

Moreover, after it is known that the electronic apparatus is in the unhealthy state of a high-temperature environment for a long time, the processor of the electronic apparatus may be controlled to use corresponding regulation measures to automatically regulate the battery state, the regulation measures are mainly embodied in optimizing the charging mode, so as to prolong the service life of the battery by means of adjusting the charging mode. Therefore, the battery is effectively protected in the charging process in conjunction with the regulation strategy.

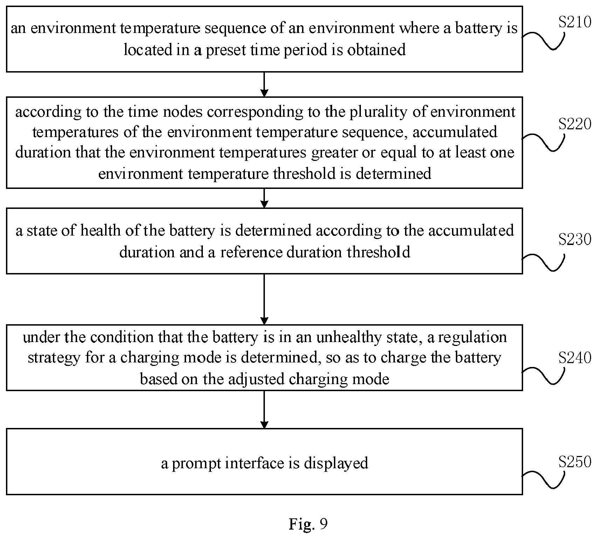

In one illustrative example, the method in the example is applied to an electronic apparatus. As shown in Fig. 9, the method in this example may specifically include:

S210, an environment temperature sequence of an environment where a battery is located in a preset time period is obtained.

S220, according to the time nodes corresponding to the plurality of environment temperatures of the environment temperature sequence, accumulated duration that the environment temperatures greater or equal to at least one environment temperature threshold is determined.

S230, a state of health of the battery is determined according to the accumulated duration and a reference duration threshold.

S240, under the condition that the battery is in an unhealthy state, a regulation strategy for a charging mode is determined, so as to charge the battery based on the adjusted charging mode.

S250, a prompt interface is displayed.

An implementation processes of steps S210 to S240 refer to steps S110 to S140 in the above example, and are not repeated here.

In step S250, when the battery is in the unhealthy state, a prompt message will be generated and sent to the display, which can then be displayed on the screen, the prompt interface is used for informing the user of the state of health of the battery in time. The prompt interface may be displayed overlaid on top of a desktop or current application interface.

In this example, the prompt interface may include a plurality of display areas. Step S250 may specifically include:
S2501, battery condition information in the preset time period is displayed on the first display area of the prompt interface.

In this step, the battery condition information includes: a state of the environment where the battery is located and the accumulated duration.

In one instance, the accumulated duration in the preset time period may be displayed overall. In another instance, environment temperature duration corresponding to each of the time nodes in the preset time period may be displayed separately. As shown in Fig. 11, the preset time period is 1 week, and a detail of the accumulated duration of the environment temperature reaching the environment temperature threshold each day in the last week is displayed on the prompt interface.

S2502, an adjustment suggestion based on the environment where the battery is located is displayed on the second display area of the prompt interface.

In this step, the adjustment suggestion includes, for instance, an environment temperature suggestion provided, based on the unhealthy state of the battery, for storing or using the electronic apparatus. For instance, based on the battery located in an environment with a higher temperature, the adjustment suggestion may indicate that the electronic apparatus is to be refrained from being used or stored in an environment above the environment temperature threshold.

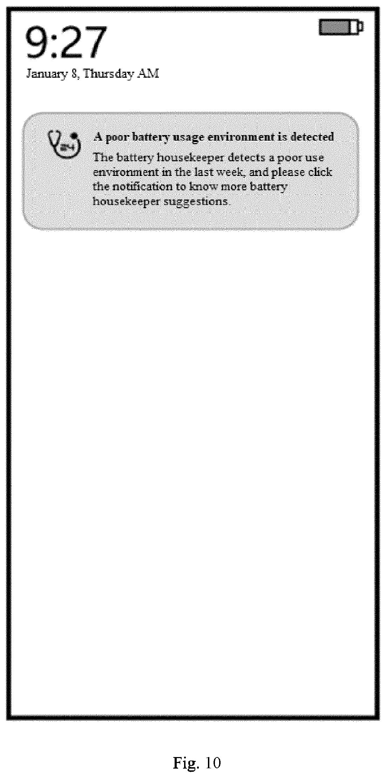

In the example, before the prompt interface is displayed, as shown in Fig.10, a notification message may be displayed in a notification bar first, and the prompt interface is displayed according to an operation instruction of the user in the notification bar.

In one illustrative example, the method in the example further includes:
S260, an operation instruction from a preset area of the prompt interface is received.
S270, the prompt interface is controlled to hiding or the regulation strategy is controlled to be executed according to the operation instruction.

In step S260, in addition to displaying prompt information in step S250, the prompt interface also sets an operation option. As shown in Fig. 11, the user may issue the operation instruction, for instance, click, double click, etc. based on two operation options, and the processor of the electronic apparatus may receive the operation instruction of the user.

In step S270, the processor of the electronic apparatus issues a corresponding control instruction according to the operation instruction of the user.

For instance, when the user clicks the operation option of "Got it" in Fig. 11, the processor controls the prompt interface to hide. When the user clicks an operation option of "Advanced setting" in Fig. 11, the processor controls the regulation strategy to be executed.

The mode in which the regulation strategy for the charging mode is determined is as recorded in steps S110 to S140, and the regulation strategy of step S140 may be specifically executed by default after determination, or may be triggered and executed based on the operation instruction as recorded in step S270.

For instance, in this step, after receiving the operation that the user clicks the "Advanced setting", the processor may control the charging voltage or the charging current to be reduced when the battery is charged in the unhealthy state, and the autonomous selectivity of the user in the process of executing the regulation strategy is improved.

In the example, the state of health of the battery is prompted for the user in combination with an UI interface of the electronic apparatus. The user may autonomously prevent the electronic apparatus from being in a high-temperature environment for a long time based on the prompt, such that a phenomenon of deterioration irreversible of the service life of the battery caused by environmental factors is avoided, and the battery life is prolonged.

It will be appreciated that in methods of other examples of the disclosure, only an interface prompt corresponding to Fig. 9 may be executed, or only the regulation strategy may be executed, after determining the battery state. Or, after the battery state is determined, the regulation strategy is determined first, then interface prompting is carried out, and finally the regulation strategy is further executed in conjunction with the operation instruction, based on the interface, of the user.

In one illustrative example, the disclosure further provides a determination device for a battery state. As shown in Fig. 14, the device in this example includes: an obtaining module 110, a first determination module 120, a second determination module 130 and a third determination module 140. The device in this example is configured to implement the method as shown in Fig. 6. The obtaining module 110 is configured to obtain an environment temperature sequence of an environment where a battery is located in a preset time period, the environment temperature sequence including: a plurality of environment temperatures corresponding one-to-one to a plurality of time nodes; a first determination module 120 configured to determine, according to the time nodes corresponding to the plurality of environment temperatures of the environment temperature sequence, accumulated duration that the environment temperatures greater or equal to at least one environment temperature threshold; a second determination module 130 configured to determine a state of health of the battery according to the accumulated duration and a reference duration threshold; and a third determination module 140 configured to determine, under the condition that the battery is in an unhealthy state, a regulation strategy for a charging mode, so as to charge the battery based on the adjusted charging mode.

In one illustrative example, the plurality of environment temperature thresholds are provided. With reference to Fig. 14, the first determination module 120 is specifically configured to determine, in the environment temperature sequence, the accumulated duration corresponding to each of the environment temperature thresholds separately. The second determination module 130 is specifically configured to: obtain first configuration information, the first configuration information including: one-to-one relations between the plurality of environment temperature thresholds and the plurality of reference duration thresholds in different time periods; determine, according to the first configuration information, the reference duration threshold corresponding to each of the environment temperature thresholds in the preset time period; and respond to at least one accumulated duration to reach the corresponding reference duration threshold, and determine that the battery is in the unhealthy state in the preset time period.

In one illustrative example, with reference to Fig. 14, the device in the example includes: an obtaining module 110, a first determination module 120, a second determination module 130, and a third determination module 140. Under the condition that the battery is in an unhealthy state, the device in the example further includes a displaying module (not shown in the figure). The device in the example is configured to implement the method as shown in Fig. 9. The displaying module is configured to display a prompt interface.

In one illustrative example, the prompt interface includes a plurality of display areas; and the displaying module is specifically configured to: display battery condition information in the preset time period on the first display area of the prompt interface, the battery condition information including: a state of the environment where the battery is located and the accumulated duration; and display, on the second display area of the prompt interface, an adjustment suggestion based on the environment where the battery is located. The device in the example further includes: a reception module configured to receive an operation instruction from a preset area of the prompt interface; and a control module configured to control the prompt interface to hide or the regulation strategy to executed according to the operation instruction.

In one illustrative example, with reference to Fig. 14, the third determination module 140 is specifically configured to adjust a charging voltage, and/or adjust a charging current. The third determination module 140 is specifically configured to: obtain an old charging voltage and a voltage adjust parameter, the voltage adjust parameter being used for adjusting the old charging voltage down; and determine an adjusted charging voltage according to the old charging voltage and the voltage adjust parameter. The third determination module is further configured to obtain an old charging current and a current adjustment parameter, the current adjustment parameter being used for adjusting the old charging current down; and determine an adjusted charging current according to the old charging current and the current adjustment parameter.

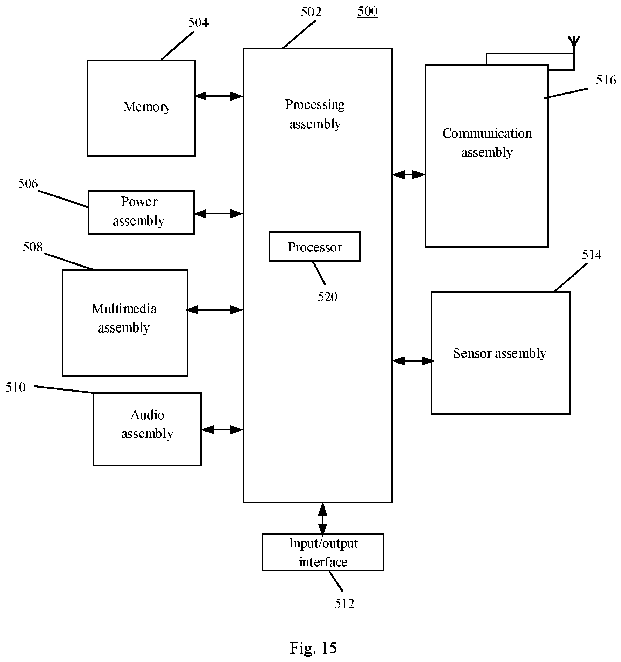

Fig. 15 is a block diagram of an electronic apparatus. The disclosure further provides an electronic apparatus. In some examples, the apparatus 500 may be a mobile phone, a computer, a digital broadcast terminal, a messaging apparatus, a gaming console, a tablet apparatus, a medical apparatus, a fitness apparatus, a personal digital assistant, etc.

The apparatus 500 may include one or more of a processing assembly 502, a memory 504, a power assembly 506, a multimedia assembly 508, an audio assembly 510, an input/output (I/O) interface 512, a sensor assembly 514, and a communication assembly 516.

The processing assembly 502 generally controls overall operation of the apparatus 500, for instance, operations associated with display, phone calls, data communications, camera operations, and recording operations. The processing assembly 502 may include one or more processors 520 to execute an instruction to complete all or part of the steps of the method above. Moreover, the processing assembly 502 may include one or more modules to facilitate interaction between the processing assembly 502 and other assemblies. In some examples, the processing assembly 502 may include the multimedia module to facilitate interaction between the multimedia assembly 508 and the processing assembly 502.

The memory 504 is configured to store various types of data to support operation on the apparatus 500. Instances of such data include an instruction, operated on the apparatus 500, for any application or method, contact data, phonebook data, messages, pictures, video, etc. The memory 504 may be implemented by any type of volatile or non-volatile memory apparatus, or a combination thereof, for example, a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk or an optical disk.

The power assembly 506 provide power to the various assemblies of the apparatus 500. The power assembly 506 may include a power management system, one or more power sources, and other assemblies associated with power generating, managing, and distributing for the apparatus 500.

The multimedia assembly 508 includes a screen that provides an output interface between the apparatus 500 and the user. In some examples, the screen may include a liquid crystal display (LCD) and a touch panel (TP). Under the condition that the screen includes the touch panel, the screen may be implemented as a touch screen to receive an input signal from the user. The touch panel includes one or more touch sensors to sense touches, swipes, and gestures on the touch panel. The touch sensor may not only sense a boundary of a touch or swipe action, but also detect duration and pressure related to the touch or swipe operation. In some examples, the multimedia assembly 508 includes a front-facing camera and/or a rear-facing camera. When the apparatus 500 is in an operational mode, for instance, a photographing mode or a video mode, the front-facing camera and/or the rear-facing camera may receive external multimedia data. Each of the front-facing camera and the rear-facing camera may be a fixed optical lens system or have a focal length and optical zoom capability.

The audio assembly 510 is configured to output and/or input an audio signal. In some examples, the audio assembly 510 includes a microphone (MIC) configured to receive an external audio signal when the apparatus 500 is in the operational mode, for instance, a calling mode, a recording mode, and a speech recognition mode. The received audio signal may be further stored in the memory 504 or transmitted via the communication assembly 516. In some examples, the audio assembly 510 further includes a speaker for outputting the audio signal.

The I/O interface 512 provides an interface between the processing assembly 502 and a peripheral interface module, which may be a keyboard, a click wheel, a button, etc. These buttons may include, but are not limited to: a home button, a volume button, a start button, and a lock button.

The sensor assembly 514 includes one or more sensors for providing state assessments of various aspects for the apparatus 500. In some examples, the sensor assembly 514 may detect an on/off state of the apparatus 500 and relative positioning of the assemblies. In some examples, the assemblies are a display and a keypad of the apparatus 500. The sensor assembly 514 may also detect a change in position of the apparatus 500 or an assembly of the apparatus 500, the presence or absence of contact between the user and the apparatus 500, orientation or acceleration/deceleration of the apparatus 500, and temperature variation of the apparatus 500. The sensor assembly 514 may include a proximity sensor configured to detect presence of nearby objects in the absence of any physical contact. The sensor assembly 514 may also include a light sensor, for instance, a complementary metal oxide semiconductor (CMOS) or charge coupled device (CCD) image sensor, for use in imaging applications. In some examples, the sensor assembly 514 may also include an acceleration sensor, a gyroscopic sensor, a magnetic sensor, a pressure sensor, or a temperature sensor.

The communication assembly 516 is configured to facilitate communications between the apparatus 500 and other apparatuses in a wired or wireless mode. The apparatus 500 may access a wireless network based on a communication standard, for instance, WiFi, 2G, or 3G, or a combination thereof. In one illustrative example, the communication assembly 516 receives a broadcast signal or broadcast related information from an external broadcast management system via a broadcast channel. In one illustrative example, the communication assembly 516 also includes a near field communication (NFC) module to facilitate short-range communication. In some examples, the NFC module may be implemented based on a radio frequency identification (RFID) technology, an infrared data association (IrDA) technology, an ultra wide band (UWB) technology, a bluetooth (BT) technology, and other technologies.

In the illustrative example, the apparatus 500 may be implemented by one or more application specific integrated circuits (ASIC), a digital signal processor (DSP), a digital signal processing device (DSPD), a programmable logic device (PLD), a field programmable gate array (FPGA), a controller, a microcontroller, a microprocessor, or other electronic elements for performing the method above.

Another illustrative example of the disclosure provides a non-temporary computer-readable storage medium including, in some examples, a memory 504 including an instruction, and the instruction may be executed by the processor 520 of the apparatus 500 so as to perform the method above. In some examples, the computer-readable storage medium may be a read-only memory (ROM), a random access memory (RAM), a compact disc read-only memory (CD-ROM), a magnetic tape, a floppy disk, an optical data storage apparatus, etc. When an instruction in the storage medium is executed by a processor of an electronic apparatus, the electronic apparatus may perform the above method.

Other embodiments of the disclosure will readily occur to those skilled in the art upon consideration of the specification and practical disclosure. The disclosure is intended to cover any variations, uses, or adaptations of the disclosure, and these variations, uses, or adaptations follow general principles of the disclosure and include common general knowledge or customary technical means in the technical field not disclosed in the disclosure. The specification and examples are considered as exemplary only, and a true scope of the disclosure are indicated by the following claims.

It is to be understood that the disclosure is not limited to the precise structure that has been described above and shown in the accompanying drawings, and that various modifications and changes may be made without departing from its scope. The scope of the disclosure is limited only by the appended claims.

## Claims

1. A determination method for a battery state, comprising:
obtaining an environment temperature sequence of an environment where a battery is located in a preset time period (S110, S210), the environment temperature sequence comprising: a plurality of environment temperatures corresponding one-to-one to a plurality of time nodes;
determining, according to the time nodes corresponding to the plurality of environment temperatures of the environment temperature sequence, accumulated duration that the environment temperatures greater or equal to at least one environment temperature threshold (S120, S220);
determining a state of health of the battery according to the accumulated duration and a reference duration threshold (S130, S230); and
determining, under the condition that the battery is in an unhealthy state, a regulation strategy for a charging mode, so as to charge the battery based on the adjusted charging mode (S140, S240).

2. The determination method according to claim 1, wherein the the determining accumulated duration that the environment temperatures greater or equal to at least one environment temperature threshold comprises:
when the environment temperature threshold is set to a plurality, respectively determining, in the environment temperature sequence, the accumulated duration corresponding to each of the environment temperature thresholds.

3. The determination method according to claim 2, wherein the determining a state of health of the battery according to the accumulated duration and a reference duration threshold comprises:
obtaining first configuration information, the first configuration information comprising: one-to-one relations between the plurality of environment temperature thresholds and the plurality of reference duration thresholds in different time periods (S1301);
determining, according to the first configuration information, the reference duration threshold corresponding to each of the environment temperature thresholds in the preset time period (S1302);
responsive to at least one accumulated duration to greater or equal to the corresponding reference duration threshold, and determining that the battery is in the unhealthy state in the preset time period (S1303).

4. The determination method according to any one of claim 1 to 3, further comprising, under the condition that the battery is in the unhealthy state:
displaying a prompt interface (S250).

5. The determination method according to claim 4, wherein the prompt interface comprises a plurality of display areas; and the displaying a prompt interface comprises:
displaying battery condition information in the preset time period on the first display area of the prompt interface, the battery condition information comprising: a state of the environment where the battery is located and the accumulated duration; and
displaying, on the second display area of the prompt interface, an adjustment suggestion based on the environment where the battery is located.

6. The determination method according to claim 4 or 5, further comprising:
receiving an operation instruction from a preset area of the prompt interface; and
controlling the prompt interface to hide or the regulation strategy to be executed according to the operation instruction.

7. The determination method according to any one of claim 1 to 6, the determining a regulation strategy for a charging mode comprises:
adjusting a charging voltage, and adjusting a charging current.

8. The determination method according to any one of claim 1 to 6, the determining a regulation strategy for a charging mode comprises:
adjusting a charging voltage, or adjusting a charging current.

9. The determination method according to claim 7 or 8, the adjusting a charging voltage comprises:
obtaining a reference charging voltage and a voltage adjust parameter, the voltage adjust parameter being used for adjusting the reference charging voltage down; and
determining an adjusted charging voltage according to the reference charging voltage and the voltage adjust parameter.

10. The determination method according to claim 7 or 8, the adjusting a charging current comprises:
obtaining an old charging current and a current adjustment parameter, the current adjustment parameter being used for adjusting the old charging current down; and
determining an adjusted charging current according to the old charging current and the current adjustment parameter.

11. An electrical device (500), comprising:
a processor (520), and
a memory (504) configured to store an executable instruction of the processor;
wherein the processor (520) executes the executable instruction to implement a determination method for a battery state, and the processor configured to:
obtain an environment temperature sequence of an environment where a battery is located in a preset time period, the environment temperature sequence comprising: a plurality of environment temperatures corresponding one-to-one to a plurality of time nodes;
determine, according to the time nodes corresponding to the plurality of environment temperatures of the environment temperature sequence, accumulated duration that the environment temperatures greater or equal to at least one environment temperature threshold;
determine a state of health of the battery according to the accumulated duration and a reference duration threshold; and
determine, under the condition that the battery is in an unhealthy state, a regulation strategy for a charging mode, so as to charge the battery based on the adjusted charging mode.

12. The device (500) according to claim 11, wherein the processor (520) is further configured to:
when the environment temperature threshold is set to a plurality, respectively determining, in the environment temperature sequence, the accumulated duration corresponding to each of the environment temperature thresholds.

13. The device (500) according to claim 12, wherein the processor (520) is further configured to:
obtain first configuration information, the first configuration information comprising: one-to-one relations between the plurality of environment temperature thresholds and the plurality of reference duration thresholds in different time periods;
determine, according to the first configuration information, the reference duration threshold corresponding to each of the environment temperature thresholds in the preset time period;
responsive to at least one accumulated duration to reach the corresponding reference duration threshold, and determining that the battery is in the unhealthy state in the preset time period.

14. The device(500) according to any one of claim 11 to 13, wherein under the condition that the battery is in the unhealthy state, the processor (520) is further configured to:
displaying a prompt interface.

15. Anon-temporary computer-readable storage medium, wherein when an instruction in the storage medium is executed by a processor of an electronic apparatus, the electronic apparatus can perform a determination method, the determination method comprising:
obtaining an environment temperature sequence of an environment where a battery is located in a preset time period, the environment temperature sequence comprising: a plurality of environment temperatures corresponding one-to-one to a plurality of time nodes;
determining, according to the time nodes corresponding to the plurality of environment temperatures of the environment temperature sequence, accumulated duration that the environment temperatures greater or equal to at least one environment temperature threshold;
determining a state of health of the battery according to the accumulated duration and a reference duration threshold; and
determining, under the condition that the battery is in an unhealthy state, a regulation strategy for a charging mode, so as to charge the battery based on the adjusted charging mode.
